# EUROPEAN PATENT SPECIFICATION

(11) **EP 2 988 140 B1**
(45) Date of publication and mention of the grant of the patent: **11.04.2018**
(21) Application number: 15396005.9
(22) Date of filing: 19.08.2015
(51) Int. Cl.: G01R 31/08

(54) **A METHOD AND APPARATUS FOR LOCATING A DISTURBANCE IN AN ELECTRICAL GRID**
VERFAHREN UND VORRICHTUNG ZUR LOKALISIERUNG EINER STÖRUNG IN EINEM ELEKTRISCHEN STROMNETZ
PROCÉDÉ ET APPAREIL PERMETTANT DE LOCALISER UNE PERTURBATION DANS UN RÉSEAU ÉLECTRIQUE

(30) Priority: 19.08.2014 FI 20140226
(43) Date of publication of application: 24.02.2016
(73) Proprietor: Eltel Networks Oy, 02600 Espoo (FI); Domax Oy, 02300 Espoo (FI)
(72) Inventor: Maksniemi, Matti, 02300 Espoo (FI); Raatikainen, Janne, 02770 Espoo (FI)
(74) Representative: Pirhonen, Kari Lennart

(56) References cited:
- US-A- 5 202 812
- US-A1- 2012 139 554

## Description

### OBJECT OF THE INVENTION

The object of the present invention is a method for locating a disturbance in an electrical grid presented in the introduction to claim 1. The particular object of the invention is a method for measuring the voltage of a medium-voltage electrical grid, such as a 20 kV electrical grid, in order to anticipate fault situations and, in case of fault situations, to isolate the location of the grid disturbance.

### PRIOR ART

Finland's electrical grid is essentially divided, administratively and technically, into three areas, which are:
1) distribution grid, which has a voltage of 230 V-400 V,
2) medium-voltage grid, which has a voltage of 10 kV-20 kV and
3) high-voltage grid, which has a voltage of 110 kV-400 kV.

Finland has more than 100,000 km of 20 kV medium-voltage grid, of which the majority runs through forests as overhead power lines. This is why the medium-voltage grid is the most susceptible to weather events, such as electrical outages caused by falling trees. The problem in this case is that it is not possible to predict a possible disturbance and, when a disturbance occurs, it is very difficult to locate the fault in the electrical grid. The reason for this is that the branch lines of the electrical grid are often multi-branched, varied in design, and long, up to dozens of kilometres. In addition, the conditions occurring during possible fault situations are also usually bad. It is often dark and windy. It may also be raining or snowing, which greatly obstructs the search for the location of the fault.

Future problems in the electrical grid should, however, be made predictable and the electrical grid should be repaired as soon as possible in a fault situation because the electrical outage may affect hundreds or thousands of households. In order to repair the fault as quickly as possible, the fault must first be located as quickly as possible. According to the prior art, however, there is no efficient means for quickly locating a fault nor especially for predicting the fault. Usually the only option is to inspect the grid visually either by moving around on the ground or from the air by helicopter so that the inspection takes place along the power line. According to the prior art, it is also not possible to predict an incipient fault. The systems only detect the fault when a low-ohm short circuit takes place in the grid. In other words, when the electrical grid is malfunctioning and the customers covered by it do not receive any electricity.

The medium-voltage grid can be measured, for example, at the supply point of the 110 kV/20 kV substation in the direction of the 20 kV electrical grid. The grid is, however, in practice, multi-branched, where the length of one branch can be, for example, 10-200 km. The length of the longest individual branch in Finland is approximately 230 km. When the location of the fault is on one of the above-mentioned live branches, it is not possible to isolate the possible location of the fault when measuring from the feeder. In a fault situation, according to the prior art, locating the fault can mean patrolling the entire length of the power line. Current technology can, at best, point out 3-5 possible branches as locations for the fault in the branch lines. Even then the measurement requires a low-impedance short circuit or earth fault. So in any case it is necessary to patrol the area, the extent of which is at least dozens of kilometres, most often even hundreds of kilometres. Different methods for locating a fault in an electrical grid have been presented in the publications
JP 2001183410 A, US 2004189317 A1, WO 9711380 A1 and WO 9708562 A1. A problem of these methods is that they cannot be used to anticipate future faults or to locate a fault quickly or accurately. Additional art is found in US5202812 and US2012/0139554. According to a known method, a low measurement voltage is fed into the electrical grid's branch lines when it lacks a line voltage. A disadvantage in this case is, however, that the customers covered by the grid are without electricity. If, in this case, the grid's electrical properties are also known, it is possible to calculate an estimate of possible fault locations. This does not, however, provide certain knowledge of the location of the fault in the branch lines. This is why it is necessary to patrol and inspect the branch lines. The branch lines of the electrical grid can, however, include hundreds or thousands of households and moving around in difficult terrain is extremely slow.

A known method is also testing the grid in a fault situation. In this case, a 20 kV line voltage is fed into the electrical grid, the purpose of which is to open, for example, a short circuit caused by a tree branch. The clear disadvantage of the method is that it is dangerous and a risk to the devices connected to the grid such as to electronic devices in industrial plants and households. The method is dangerous because it is possible that one or more conductors have fallen to the ground in the fault situation. As moist soil conducts electricity, a high electrical voltage causes a possible life-threatening hazard to the people and animals in the area. This type of testing also causes powerful electricity peaks in the grid, which causes the electricity to "flicker" in common terms. This is potentially harmful for any devices connected to the electrical grid.

Single, spherical measurement sensors that are hung on the conductors can also be used to inspect the condition of the electrical grid. The purpose of their function is to indicate the direction in which the impulse caused by the disturbance in the medium-voltage grid is travelling. The considerable disadvantage of the method is that someone must visit the site to see whether the electrical grid's disturbance has passed through the ball sensor. The problem with ball sensors is their cost level and installation difficulty. The point of measurement can only be installed in a non-live medium-voltage grid which is inconvenient for households, for example, because the electric current must be cut for the duration of the installation work.

Transmission system operators are in a difficult position because power cut compensation is becoming more expensive, causing the damages resulting from unanticipated interruptions to pose a significant burden to grid companies. In addition, weather events seem to be becoming more severe, but there is no adequate, cost-effective measurement method for measuring medium-voltage grids according to the prior art.

### PURPOSE OF THE INVENTION

The purpose of a method according to the invention is to achieve a new, more efficient and faster method for measuring the electrical grid, such as the voltage and disturbance impulses of a mediums-voltage grid, anticipating fault situations and locating any faults occurring in the electrical grid.

### CHARACTERISTICS OF THE METHOD

A method according to the invention is characterized in what has been presented in the characteristics section of Claim 1.

According to a method of the invention, a disturbance in the electrical grid is located so that
- several measurement points placed at some distance from one another are placed along a three-phase power line, the measurement points including a remote detector intended for each phase conductor at a distance from the phase conductor,
- using the remote detectors, the strength of each phase conductor's voltage field is measured separately at the measurement point, and
- the location of the power line's disturbance and/or fault is predicted and/or isolated using a measurement of the change in the strength of the conductor's voltage and/or voltage field.

According to a method according to the invention, a future fault occurring in the power line can be located and predicted using the change in the strength of the conductor's voltage field in such a way that if, at the measurement point, the strength of the voltage field of a single phase conductor clearly changes compared to the strengths of the other phases' voltage fields, then the possible disturbance and/or fault in the electrical grid is located in the area in which the measurement point is located.

According to a method according to the invention, the fault in the power line can be located using a voltage impulse occurring in the conductor's voltage field, created by the fault, in such a way that the precise arrival time of the impulse is registered at different measurement points and the arrival times are compared with one another, whereby the distance of the fault from the different measurement points can be calculated and the location of the fault isolated in the electrical grid.

According to a method according to the invention, a real-time or saved status of the 20 kV grid's electrical situation is assembled for use by the grid company's control centre. The status is created, for example, on a monitor screen in such a way that the measurement data generated by the electrical impulses are measured from the grid's measurement points to the nearest microsecond. An expert working in the electrical grid control centre uses this data to monitor faults that are developing, already exist or that have already been repaired. The method is extremely advantageous in managing and inspecting an electrical grid compared to currently known methods. According to the method, it is even possible to predict a developing fault and isolate it to within approximately the nearest 2 kilometres. In practice the prediction time can even be extended to approximately four hours. Using the known methods there is no prediction time.

The measurement results for the electrical grid are used primarily for anticipating and isolating faults possibly developing in the electrical grid and, when problems occur, for isolating the location of the fault in the electrical grid. Because, according to the invention, it is possible to isolate the location of the fault quickly, the method enables the starting up of repair work even ahead of time or immediately once the fault has been confirmed. Thus electrical outages, which are disadvantageous in many ways, can be repaired decisively faster or even be prevented because, according to current practices, hours, if not days, are spent searching before the location of the fault is discovered. The method enables, in a novel way, the prediction of a fault developing in an electrical grid and the isolation of its location.

It is essential to the method that it can even be used to anticipate a gradually developing disturbance that is likely to become worse, and will normally result in an electrical outage. An electrical outage or other fault can be prevented if it is detected in time, in which case a disturbance developing in the electrical grid can be preventively eliminated on-site. A fault often begins to develop when the branch of a tree lightly touches a 20 kV conductor. In practice the prediction time of a fault causing a power outage has been as much as four hours.

According to the invention, the measurement of the voltage and disturbance impulse are performed without physically touching the medium-voltage grid's overhead line and the measurement results can be read at the electrical grid's control centre in real time. The fast isolation of the location of the fault significantly speeds up the repair of the fault and reduces the duration of power outages.

The measurement result involves the following things, among others:
1) alterations in the voltage level of the different phase conductors of a 20 kV three-phase electrical grid
2) travel direction of a voltage spike or disturbance impulse and
3) isolation of the location of a fault using the electrical grid's disturbance impulses.

The location of a fault in the electrical grid can be isolated very precisely depending on what kind of location along the electrical grid the fault occurs at and how close to the measurement sensors the fault is, for example, at least to within approximately the nearest 1-5 km. A practical example is a situation in which a 20 kV electrical grid is located along marshy or lake-filled country or otherwise difficult terrain. According to the method, the repair team is directed along the most accessible route directly to the location of the fault. When the location of the fault is known it is also known, among other things, what the electrical grid's cross-arm structure is like in the area in question, allowing the repair team to secure the correct spare parts even before beginning the repair work and travelling to the location of the fault.

### APPARATUS

An object of the invention is also an apparatus for measuring the electrical grid's voltage and disturbance impulses and predicting faults in the electrical grid and isolating the locations of faults that have already come into existence.

### CHARACTERISTICS OF THE APPARATUS

An apparatus according to the invention is characterized in what has been presented in the characteristics section of the independent apparatus claim. An apparatus according to the invention can be an entire system through which a method according to the invention can be implemented.

An apparatus according to the invention constitutes several measurement points located at a distance from one another along the power line of a three-phase electrical grid, each of which has a remote detector intended for a phase conductor at a distance from the phase conductor and that the remote detector measures the strength of the phase conductor's voltage field in order to anticipate and/or isolate the location of the power line's disturbance and/or fault using the change in the strength of the conductor's voltage and/or voltage field.

The measurement point of the apparatus according to the invention has a remote detector that measures the strength of the phase conductor's voltage field separately in the vicinity of each phase conductor and the apparatus includes a voltage field strength comparison member for the phase conductors that is arranged to anticipate a fault in the electrical grid possibly occurring within the area of the measurement point if the strength of the voltage field of one phase conductor at the measurement point deviates clearly from the strengths of the other phases' voltage fields.

The apparatus according to the invention includes, at the measurement points:
members measuring time, which maintain the electrical grid's measurement points at precisely synchronous time,
- members for detecting a voltage impulse in a conductor,
- members for registering the time at which the voltage impulse arrives at the measurement point,
- members for reporting the arrival time of the impulse to the electrical grid's control centre, and, at the control centre, members for isolating the location of the fault based on the arrival times of the impulses reported by the measurement points.

The method according to the invention has been found to be effective and the apparatus according to the invention has been tested successfully in an active 20 kV medium-voltage grid. According to the invention, the system uses a measurement apparatus which is a remote detector of an electrical grid's voltage. The remote detector includes a sensor, which enables the establishment of the voltage of the electrical grid's conductor from a distance from the conductor without having to touch the conductor. The apparatus is particularly suitable for a high-voltage or medium-voltage electrical grid because the apparatus is not installed onto the conductor but at a distance, such as, for example, approximately 1 m away. The measurement apparatus is easy to install in a medium-voltage grid because it is installed on an auxiliary cross-arm of the utility pole, for example, while the voltage of the electrical grid, such as, for example, the 20 kV line voltage, is turned on. The apparatus is small and it has affordable acquisition, installation and operating costs.

The apparatus according to the invention will achieve a clear improvement compared to known apparatuses because the apparatus is not galvanically coupled to the electrical grid. The apparatus also measures and anticipates possible problems occurring in the electrical grid even before an actual problem has arisen. In fault situations the isolation of the location of the fault can be carried out quickly and precisely. The apparatus's measurement results can be read in real time as it is composed of, in addition to the voltage sensors, an on-site computer, a telecommunications device for forwarding measurement results to the control centre, where the data is received and processed.

According to the invention, the measurement points composed of voltage sensors are installed in the electrical grid at a distance from one another so that the length of the conductor between the measurement points is approximately 5-10 km. The measurement points' measuring equipment functions independently but extremely accurately in synchronous real time. As the installation locations of the equipment and the lengths of the conductors between them are known, the distances of the fault's locations from the measurement point can be determined from the measurement results.

A key characteristic of the apparatus according to the invention is the measurement of the disturbance impulse's direction of travel and travel time to the nearest microsecond and remote measurement of the electrical grid's voltage level in field conditions in real time. By combining the measurement results for the different measurement points at the control centre, a clear overall picture of the precise time that the disturbance impulse came into being and the area it impacts is achieved. The data supplied by the overall picture can, if needed, be further combined with any other data related to the fault. Based on this, the installers performing the grid repair work and the materials can be quickly directed to the location of the fault.

In practical situations changes and disturbances in voltage have been measured and verified according to the invention in the electrical grids used in a grid company's production. In such cases it has been clearly detected, for example, that a tree branch has touched an overhead power line or a bird has touched the structures in such a way that it has caused a short circuit. By combining the measurement results for the different measurement points at the control centre, a clear overall picture of the grid in real time can be obtained.

### STRUCTURE OF THE MEASUREMENT APPARATUS

The medium-voltage measurement apparatus according to the invention constitutes the following parts:
1) One measurement sensor for each conductor. A measurement point in a three-phase electrical grid has three sensors which are most advantageously located at the ends and in the middle of a horizontal auxiliary cross-arm to be installed on a utility pole. The cross-arm is installed below the utility pole's cross-arm supporting the conductors, such as at a distance of 1 m.
2) An on-site computer that is also located on the auxiliary cross-arm or on the same utility pole. Power supply for the on-site computer is arranged either from an intersecting 230 VAC electrical grid and/or, for example, from a solar panel. The on-site computer is designed and industrially manufactured precisely for this purpose. The design includes the design of an electrical circuit diagram, selection of the electronic components according to calculations and software that has been created specifically for the operations of the apparatus according to the method in question.

The on-site computer constitutes the following key elements:
1) Voltage measurement sensor
2) Apparatus for measuring the voltage level and detecting disturbance impulses
3) Impulse time stamping unit
4) Telecommunications unit
5) Power unit
6) GPS unit
7) CPU
8) Enclosure

The following is a more detailed description of the above-mentioned parts of the on-site computer and their function:

### 1) VOLTAGE MEASUREMENT SENSOR

Three measurement sensors are located in the auxiliary cross-arm of a utility pole at a measurement point of a medium-voltage electrical grid such that each of the three phase conductors has one measurement sensor. The auxiliary cross-arm and measurement sensors are located most advantageously approximately 1 m from the phase conductors, whereby the voltage measurement takes place remotely and the measurement sensors are not galvanically coupled to the conductors. The measurement sensor constitutes two copper plates close to one another, a twisted pair cable and a small apparatus enclosure. The functioning of the measurement sensor is based on a physical phenomenon, according to which potential difference develops in the electric field between the copper plates. The potential difference can be described using the formula E = V/m, in which E = potential difference, V = voltage and m = distance between the plates. The potential difference closely monitors changes in the 20 kV conductors' voltages in real time. The potential difference is transferred to the on-site computer using a coupling cable which is located on the same utility pole.

### 2) APPARATUS FOR MEASURING VOLTAGE LEVEL AND DETECTING DISTURBANCE IMPULSES

The other parts of the on-site computer, except for the sensor, are located in the on-site computer's apparatus enclosure coupled to the utility pole. The apparatus in the enclosure for measuring the voltage level and detecting disturbance impulses is a large input impedance amplifier that changes the potential difference coming from the sensor
- into the voltage range of approximately 0-4.5 V DC. Each sensor has its own amplifier. The achieved measurement result is called a trend measurement although the real time of the measurement sequence is only 1-10 seconds.
- into an impulse in the voltage area of approximately 0-4.5 V DC, and rapid voltage changes are segregated by derivating dv/dt with an analogue filter circuit. The filter parameters are adjusted remotely if needed from the electrical grid's control centre in real time. The parameters are dv/dt and the voltage amplitude, i.e. the size of a voltage spike. Capacitor, resistor, coil and trigger voltage levels with appropriate standby currents are used for filtration. Digital circuit board switches, the remote controlling of which takes place through the on-site computer's microprocessor, are used for controlling.

The on-site computer sends the trend measurement's result to the electrical grid's control centre where it is processed, for example, so that it can be viewed on a web browser and saved for any future needs. After this the impulse data is fed into the on-site computer's time stamping unit.

### 3) IMPULSE TIME STAMPING UNIT

The on-site computer has one counter implemented with sequence logic, which repetitively counts from 0 to 999999 each second. The counting rate is crystal-controlled. The rate oscillation of the crystal control is insignificantly small. The electrical grid has several measurement points, each of which has one counter, which are synchronised with one another to an accuracy of at least 10 nanoseconds.

The counters are reset using the GPS device's PPS (Pulse-Per-Second) signal. Thus the counter of each of the measurement points on the electrical grid is always set to the same time, which is more precise than one microsecond, i.e. approximately 10 nanoseconds. When the filter circuit allows the impulse to pass through any of the three phases the impulse in question is translated in approximately five nanoseconds into the digital state, i.e. "0" or "1", the corresponding voltages of which are approximately 0 V or approximately 5 V. This digital signal travels through a 3-input NAND gate. It accepts an impulse from one of the three-phase system's electrical phases.

The signal locks, within approximately five nanoseconds, the above-mentioned counter, in which case the counter stops at a value between 0 and 999999. The counter stops and remains locked, reports its status and waits for permission from the on-site computer's microprocessor to continue counting. Usually the counter is given permission within approximately five seconds. Using the sequence counters is justifiable in that they function reliably at an accuracy of a few nanoseconds, which software-controlled microprocessors are not necessarily capable of.

The counter now has a new saved value between 0 and 999999, which does not change. The microprocessor reads the saved value and allows the counter to continue counting. The counter's counting synchronises during the space of, at most, one second when it receives the next PPS signal. The on-site computer sends the read value to the electrical grid's control centre within approximately ten seconds. The electrical grid's control centre receives the value between 0 and 999999, read at several measurement points. The differences between the values from difference measurement points usually vary between 1 and 100. When the values from two adjacent measurement points are compared, the difference between the values indicates, for example, from which direction the impulse has come from.

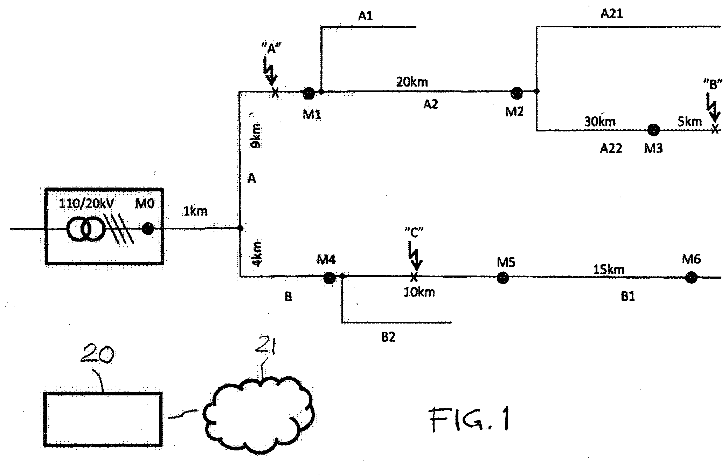

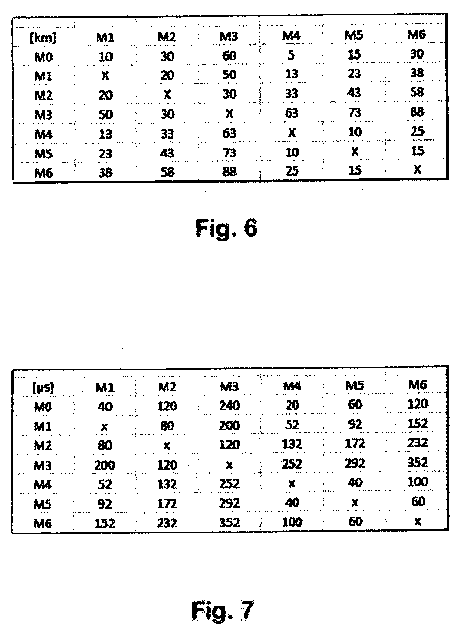

In the table in Figure 7, for example, the value 120 appears in adjacent columns M2 and M3, which describe the electrical grid's measurement points. It can be deducted from the table that the lower counter value in the adjacent measurement points signifies the direction in which the impulse is coming from. If the differences between the values in the same rows of table 7's columns M2 and M3 are calculated and column M3's value is smaller than the value in column M2, the impulse has come from the direction of the measurement point M3. In Figure 1 an impulse such as this is, for example, impulse "B" because the counter at measurement point M3 has stopped and locked earlier.

For example, the difference between the values 540000 and 539880 is 120 and similarly the difference between the values 123456 and 123576 is 120 but when comparing the values received within the space of one second from the different measurement points' measurements with one another, the distance of the impulse's starting point and direction from which it is coming can be established.

If the difference between the received values is smaller than what the physical distance between the measurement points along the overhead line and what the speed of the impulse of about 250 m/µs would require, the impulse was generated between the two measurement points. In this case it is also possible for the two measurement points to report the exact same measured numerical value when the impulse was generated exactly at the middle point of the overhead line between them, i.e. the distance from the impulse point along the conductor is the same to both measurement points.

### 4) TELECOMMUNICATIONS UNIT

The telecommunications unit comprises a mobile telephone network modem, which includes a SIM card and a Transmission Control Protocol. Their technology is integrated onto the same circuit board on the on-site computer in order to guarantee the apparatus's functionality and reliability. In order to improve the reliability of the telecommunications unit the unit is monitored and controlled by the microprocessor, which improves the equipment's quality and usability. M2M (machine-to-machine) connections over the mobile telephone network have not proven to be reliable.

### 5) POWER UNIT

The power unit consists of a 230 V/12 V transformer and a 12 V/5 Ah battery. The apparatus receives its operating power from a 230 V AMKA conductor located in the 20 kV area. The battery is dimensioned so that it is sufficient to power the apparatus for approximately 24 hours of use. The battery also filters disturbances coming from the 230 V electrical grid.

### 6) GPS UNIT

The GPS unit is integrated onto the on-site computer's circuit board. The PPS signal of a known GPS unit has been improved because the PPS signal of commonly available GPS cards has a small, approx. 1-2 ns variation in the rising edge of the digital impulse. Its significance at approximately the 1.5 V position is about 1-2 ns at the impulse's rising edge. Thus the PPS impulse of the normal GPS card is not an ideal digital impulse at a 90-degree rising edge. The usability of the GPS card has been improved by adding a fast analogue comparator for PPS signal reading, which is triggered at approx. 0.5 V, minimising the GPS card's PPS signal so that it becomes inconsequential.

### 7) CPU

The measurement point's microprocessor is a microcircuit integrated onto the circuit board. Its task is to control the entire on-site computer. As presented above, the time-critical time stamping of the impulse, among other things, is carried out using sequence logic, such that the sufficient quality of the performance of the microprocessor's microcircuit is ensured.

The software run by the microprocessor is developed for the application in question. It is functionally advantageous because the microprocessor does not, in that case, have any additional tasks, and the microprocessor's software and the microprocessor's analogue and digital signal have been adapted to operate well together. The software of the microprocessor works mainly locally but it uses adjustable parameters which are given different values from the electrical grid's control centre in real time. The parameters use, for example, the impulse's dv/dt band-pass filters' capacitors, coils and resistors. In addition to these, the time ranges of the reporting periods, among other things, can be controlled remotely.

### 8) ENCLOSURE

The enclosure is a weather-proof enclosure, which simultaneously serves as an installation platform for the on-site computer. It is thus advantageous for the installation to be simple and for the enclosure to withstand variations in the weather.

The software used by the microprocessor is uploaded into the circuit board's memories prior to use or during use either locally or remotely from the control centre. The apparatus's measurement sensitivity and other controls related to measurement can be changed in real time remotely from the control centre. The control centre contains the database server and software which are used to process the measurement results arriving there in such a way that the required data can be retrieved from the electrical grid, such as, for example, the locations of disturbances developing or already detected in the electrical grid.

### USAGE

According to the invention, the measurement points are installed on the utility poles of a 20 kV medium-voltage grid's overhead lines at a distance of 5-10 km from one another. The measurement points' apparatuses have been preconfigured and they begin to immediately produce measurement data, which they send within approximately 30 seconds to the electrical grid's control centre. The measurement data is collected and merged at a control centre to produce information on the medium-voltage grid's state, problems and possible fault locations. An integral and essential data record attained from the measurement is a time measurement result, given to within the nearest microsecond, of the travelling of the disturbance impulse "past" the measurement point. The transfer time of the measurement data as a data record of the measurement point to the electrical grid's control centre does not impact the measurement result.

According to the invention, an overview of the medium-voltage grid based on the measurement points is achieved when the single impulse has passed each measurement point. When the measurement accuracy is +/-2 microseconds, this means that the impulse propagation can be monitored at an accuracy of about 1.5 km even if the impulse travels along the conductor at approximately 250 m per microsecond. When the variations in the shape of the impulse, among other things, are added to the measurement result, the measurement accuracy declines slightly and is approximately 2 km. This is, however, an excellent level of accuracy compared with known methods according to the prior art, according to which the result can be the entire length of the medium-voltage grid's branch lines, i.e. dozens of kilometres or even 10-200 km.

The method and apparatus according to the invention measure the strength of the electric field's potential difference E=V/m. According to the invention the measurement of a change in the strength of the electric field is used in a novel way to anticipate any problems forming in the electrical grid already beforehand. An incipient fault in an electrical grid causes a clear change in the discernible measurement result. The change is very local, within the area of just one or a few measurement points but it signifies the isolation of an incipient fault or an already existing fault.

According to the invention, a preliminary warning of a developing problem is achieved in a three-phase electrical grid such that when measuring the strength of the electric field using sensors according to the invention, a change in the strength of the electric field is detected within an area of one or a few measurement points. The change can be such, for example, that the strength of the electric field measured in the vicinity of one of the phases' conductors decreases. At the same time, however, the strengths of the two other phases' conductors increase as a type of compensation.

The changes in the strengths of the electric fields in the conductors may result from, for example, a tree touching one of the power line's conductors, which may then, after some time, fall entirely onto the power line. In this case, according to the invention, a preliminary warning of an incipient problem developing on the power line is given well ahead of time. As, according to the invention, such changes in the strength of electric fields are only possible to detect within a limited area, this also provides precise data on where the incipient problem in the electrical grid is located.

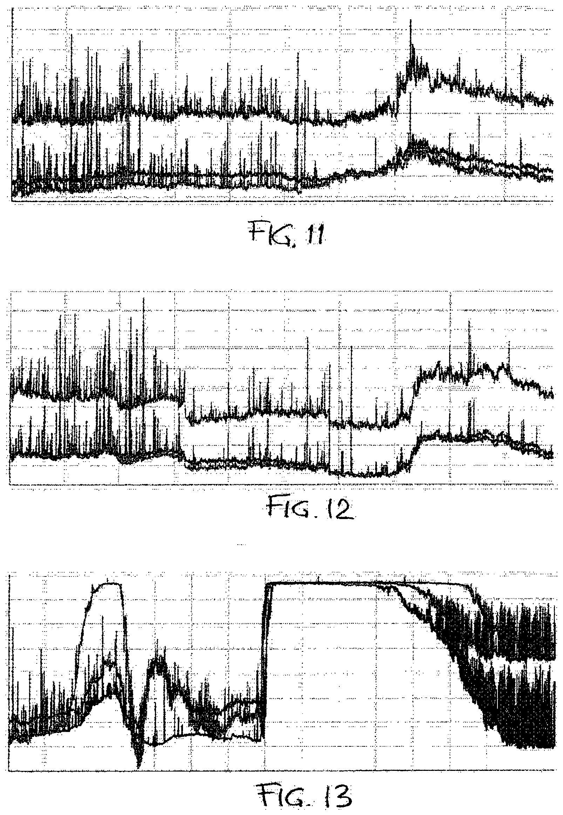

When measuring the voltage of the electrical grid's conductor, according to the prior art, using a galvanically coupled measurement apparatus, changes in voltage can also be detected. In this case, however, the change occurs within the entire grid, which means that no precise, significant data on the location of a possible problem can be obtained using the prior art. This is an extremely significant and crucial difference between the methods according to the prior art and the invention presented in the application, because, according to the invention, the voltage field (E=V/m) is measured. When the voltage field is measured using the method and apparatus according to the invention, the disturbance area is clearly visible within a limited area, as presented in Figures 11, 12 and 13. This enables the fault in the electrical grid to be located substantially more efficiently.

Using the method and apparatus according to the invention both voltage impulses travelling in the grid and changes in the strength of the electric field can be measured from the electrical grid, making it possible to combine the results of the impulse and field intensity measurements.
This allows the fast and precise positioning of a fault on the power line map of the electrical grid's control centre for an operating, faulting or already malfunctioning electrical grid. This is not possible using the known methods and apparatuses.
According to the method, it is possible to know the starting time of the disturbance at an accuracy of about 1 second, for example. The starting time of the disturbance is not, however, such significant information as the data produced by the measurement points at an accuracy of one microsecond. This data shows unequivocally from which direction the disturbance has come and where it has gone. At the start of the disturbance a precise indication is received from between the measurement points at an accuracy of about 2 kilometres. If the disturbance begins outside the area between the measurement points, this also means a measurement result even though the starting time of the disturbance is not known at this point. In this case the disturbance would be coming from an area that had not been planned to be monitored for disturbances.

The measurement points are selected according to the structure of the grid to be monitored and the terrain. It is important for the grid operator to know whether the fault is, for example, on top of a hill, on an island, in a marsh or in a field in a forest. Another important piece of data is in which fault disconnector section the fault is in and what kind of cross-arm structure is in the fault area. Using this data a decision can be made of how to access the fault area. Defining the route to be used is also dependent on the distance that needs to be covered by vehicle on roads or in terrain, or whether a boat is required, and which materials and equipment need to be taken along. The extent and type of customer base also impacts the planning and location of the measurement points.

When the variations in the shape of the arriving impulse, among other things, are added to the measurement result, the measurement accuracy for isolating the disturbance declines slightly and is usually approximately 2-5 km. This is, however, an excellent level of accuracy compared with known methods according to the prior art, according to which the accuracy of isolating the disturbance's location can be the entire length of the medium-voltage grid's branch lines, i.e. dozens of kilometres or even 10-200 km. Using the method according to the invention enables the detection, with a high level of certainty, of which of the branches of the medium-voltage grid is faulty. Even this in itself is extremely valuable data for persons managing the grid repairs because they will be able to immediately direct, with certainty, the persons carrying out the repairs to the established fault area.

The method and the apparatus according to it provide preliminary data on incipient faults. This gives the electrical grid's control centre time to prepare for shutting down the malfunctioning section of the grid. In practice, this enables the controlled placing of only a section of the entire grid in fault mode. For example, if the grid covers 5000 homes, the incipient fault can be limited, depending on the situation, to only apply to 500 households, for example, instead of the entire grid being taken off-line. To prepare for this, the grid company requires at least an approximately 15-minute advance warning. This is not enabled by currently known methods and apparatuses but using the method and apparatus according to the invention, the anticipation time is most advantageously approximately four hours. According to the invention, a fault can be prevented in the entire grid without any part of the area being demarcated as a fault area. If, for example, when using the known methods and apparatuses, the fault area is 5000 households, according to the invention most advantageously no households will be part of the fault area because the formation of the fault can be pre-emptively prevented.

According to the views of the applicant, the method presented above is novel, involves an inventive step, and is susceptible of industrial application. None of the known methods enable real-time, financially advantageous predictive measurement and fault isolation. The above-mentioned publications of prior art have presented the measurement of, among other things, 0.4 kV grid disturbances in cable networks or theory of mathematical models. The solution according to the invention and the method and apparatus presented therein are primarily related to overhead lines.

The essential characteristics of a solution according to the invention are the following:
1. The apparatuses are installed safely while the line voltage of the medium-voltage grid is switched on. This prevents unnecessary outages to, for example, households.
2. The voltage level and electric impulses of the medium-voltage grid are measured without touching the conductor.
3. The measurement result transfers in real time from the location in the field to the control centre of the invention and is immediately available. A delay in the apparatus may, however, in some cases last approximately 30 seconds.
4. Voltage changes in the medium-voltage grid and the impulses indicating them are received by the control centre in real time from the different areas of the grid. Small voltage changes and the weak impulses indicating them can be caused, for example, by snow load or a tree beginning to lean against a conductor, in which case a small branch first leans against it and then finally the entire trunk. When small fault notifications such as this are received at an early stage the condition of the grid can continuously be monitored better and it is possible to prepare in advance for any maintenance work. According to the prior art, monitoring an electrical grid in this way is not possible which is why, according to currently used methods, the electrical grid is not repaired until after a fault has occurred in which case the power outage may already affect hundreds of households.
5. The magnitude and direction of travel of the disturbance impulses occurring in a medium-voltage grid can be measured. This means that, for example, any faulty or excessive loads can be located within the medium-voltage grid. This simultaneously improves the quality of the electricity and enables the controlling of the grid's dynamic loads, otherwise there would be no data on their variations at all.
6. Major disturbances in the medium-voltage grid are isolated decisively faster and better than according to the known methods, for example, just moments before the grid's power shuts off due to, for example, an earth fault.
7. The measurement sensitivity of the measurement points can be set at the required level and they can be adjusted remotely in real time from the control centre.
8. The control centre receives, saves and processes the relevant information from the measurement data as data records and in visualised form so that it can be used together or separately with the control and/or monitoring systems owned currently by the grid.
9. A flexible apparatus is accomplished by means of the invention, for example, a minicomputer with software for measuring the electrical grid.

In the following, the invention is described using examples with reference to the appended drawings, in which

### LIST OF FIGURES

- Figure 1: shows a schematic view of a 20 kV medium-voltage grid according to the invention.
- Figures 2 and 3: show a side view of a measurement point according to the invention attached to a utility pole.
- Figure 4: shows a schematic side view of a measurement point according to the invention.
- Figure 5: shows a schematic view of a measurement point and a control centre according to the invention and the telecommunications between them.
- Figure 6: shows a table which contains the distances between the measurement points in a measurement apparatus system according to the invention.
- Figure 7: shows a table which contains the impulses' travel times in a measurement apparatus system according to the invention.
- Figure 8: shows a table which contains the distances of the disturbance points in the electrical grid from the measurement points in a measurement apparatus system according to the invention.
- Figure 9: shows a table which contains the disturbance impulses' travel times from the electrical grid's disturbance point to the measurement points in a measurement apparatus system according to the invention.
- Figure 10: shows another 20 kV electrical grid which has measurement points according to the invention.
- Figures 11-13: show measurement curves for an apparatus according to the invention.

### DESCRIPTION OF THE FIGURES

Figure 1 shows a schematic view of a 20 kV medium-voltage grid according to the invention, which is a typical medium-voltage grid right-of-way. The majority of the electrical grid is usually located in forest where trees grow quickly. In the winter or during storms trees bend and some of them may fall against conductors. This often causes an outage in the entire grid. Trying to isolate the location of the outage in the known manner is difficult because conditions at the time of the event are usually extremely poor. In addition, a branch line of the electrical grid can be up to 10-200 km long, making it difficult and slow to locate a single fallen tree.

In the example of Figure 1 the electrical grid has two main branches A and B. In branch A the first measurement point M1, which has measurement sensors according to the invention, is 10 km from the transformer substation M0. The distances of the other measurement points M2 and M3 have been marked in Figure 1. Similarly branch B has three measurement points M4, M5 and M6. The distances of all of the measurement points from the transformer substation M0 have been marked in the table in Figure 6. The measurement points are in the same real time and they inform the electrical grid's control centre 20 through a telecommunications network 21.

Figure 1 is a rough representation of the structure of a medium-voltage grid. On the left is a 110/20 kV transformer substation M0, which supplies the 20 kV medium-voltage grid with power. In principle the entire branch line has approximately the same voltage, i.e. voltage on, fault voltage or zero volts. The measurement points M1, M2, M3, M4, M5 and M6 are located in the grid such that the distances between them measured along the conductor are known precisely. Each of the measurement points is connected to the control centre 20 as an independent unit. The measurement points are precisely mutually synchronised. At the control centre the data is received and processed to be structurally and visually appropriate. The control centre can, if required, send control commands to each independent measurement point.

For example a fault in one branch of the medium-voltage grid causes both a change in the strength of the voltage field and a strong voltage impulse. It travels at close to the speed of light along the conductor in different directions in the grid. After a moment, the impulse will have travelled past all of the measurement points and they will have registered the moment the impulse took place at an accuracy of one microsecond. In this way each of the measurement points attains its own measurement reading which correlates linearly with the distance travelled by the impulse from its starting point. These readings are "placed" on the control centre's power line map and this reveals the starting point of the impulse.

Smaller impulses fade as they travel in the grid. This is also a measurement result because the measurement of the measurement points' voltage level isolates the strength of the voltage. It is clear that the closer the measurement point is to the impulse's starting point, the greater the impulse it measures. In addition to the two previous measurement results, a clear reading of the impulse's direction of travel is attained based on the measurement points' results. It is a good measurement result because the travel time of the fading impulse lengthens in terms of the measurement when the impulse's amplitude weakens and the gate trigger voltage of the measurement points is the same.

In the example shown here impulse "A" hits the conductor at measurement point M1. Impulse "B" hits the conductor approximately 5 km to the right of measurement point M3. Impulse "C" hits the middle of the conductor between measurement points M4 and M5. In principle, an impulse can hit any part of the medium-voltage grid. This random impact point is measured according to the method, which is the solution to the problem.

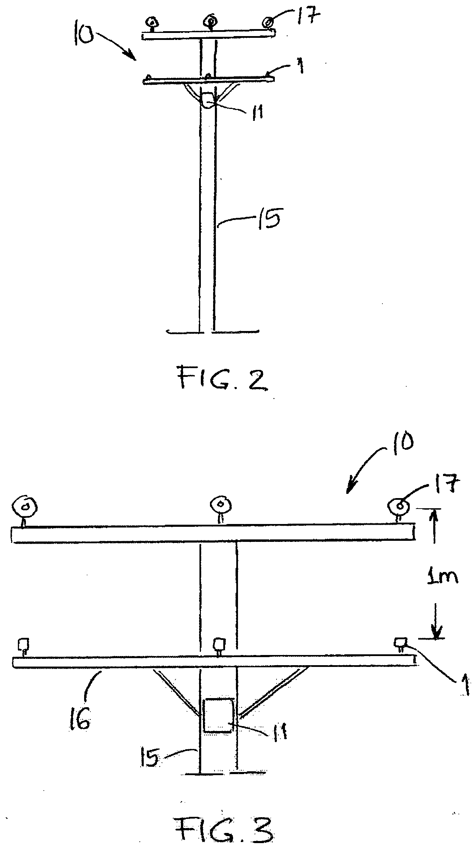

Figure 2 shows a measurement point 10 according to the invention, which is located on a utility pole 15. Figure 3 shows a more detailed view of the structure of the measurement point 10. The measurement point 10 constitutes measurement sensors 1, of which there are three, i.e. one sensor for each conductor 17, located on an auxiliary cross-arm 16 attached to a utility pole 15. The measurement sensors 1 are located approximately 1 m from the three-phase grid's conductors 17. The size of the auxiliary cross-arm is approximately 2 m x 1 m and it weighs approximately 10 kg. An on-site computer 11 coupled to the utility pole 15 receives its operating power from the 230 V distribution grid intersecting the medium-voltage utility poles. Two installers are required for installing the ready-to-operate measurement point 10 and only approx. 30-90 minutes are required for installation. What is essential is that the work can be carried out with a live grid, i.e. in a medium-voltage grid with the 20 kV line voltage turned on. Each measurement sensor 10 is installed about 1 m from the conductor 17.

In the example assumed here, a tree has begun to rub against a power line. Each of the three phases are measured separately at the measurement point 10, and thus it is discovered that the voltage of one phase is beginning to rise in comparison to the other two. This phenomenon is normal in a fault situation when a delta circuit electrical grid begins to support the large load of one phase over the two other phases. It can also be detected how the tree eventually causes large voltage spikes.

The method according to the invention indicates the problem well before a fault situation occurs. The power company's grid control centre begins to detect it. According to the prior art, the power company only measures the voltage at the 110/20 kV feeder but is not able to determine in which branch the fault is developing. In order to isolate the location of the fault the grid company should be able to carry out the measurements in a dead grid, which must first be de-energized. The power company must know the grid's impedance and the physical length of the conductor. By feeding a small pilot voltage into the grid the impedance according to the fault situation can be measured from the grid, which, when compared to the impedance of the undamaged grid, can be used to, to some extent, determine possible fault locations. There are, however, several such possibilities and often it is still unclear what the precise location of the fault is.

The method according to the invention is different and helps isolate fault points more effectively and precisely in fault detection situations, enabling repair work to be begun faster. The system according to the invention detects a rapid change in voltage (dv/dt) and is triggered. A slower, trend-like voltage change in the grid is measured but the system is not, by design, triggered.

Using the remote voltage detector for electrical grids according to the invention, it can be determined whether there is a voltage in a high-voltage electrical grid's high-voltage conductor. The remote detector comprises a sensor by means of which sensor the voltage of a high-voltage conductor can be detected at a distance from the conductor. A voltage in a high-voltage electrical grid's conductor is detected in such a way that the remote detector is brought into the vicinity of the conductor, at a distance from the conductor, in such a way, however, that the distance of the remote detector from the conductor is greater than the required safe distance. On the basis of the signal provided by the sensor of the remote detector, it is detected at a distance from the conductor whether a voltage is present in the high-voltage conductor, without having to touch the conductor.

For example, fault situations in a 20 kV medium-voltage grid are difficult. The falling of a tree onto conductors in one branch of the grid causes a large power outage, which can impact thousands of households or electricity consumption sites. Often a fault situation develops in poor prevailing conditions, when it is dark, cold, windy and snowing. Isolating the location of the fault can take hours because the branch line can be 100-200 km long. In addition attempts must be made to prevent the impact of a swaying tree falling on a power line or of a snow load. The invention enables real-time remote measurement and provides an overview of the voltage variation, the electric impulse's direction of travel and the point where the impulse generated by the problem began to an accuracy of a few kilometres. The method and apparatus are affordable as an apparatus and in terms of operating costs.

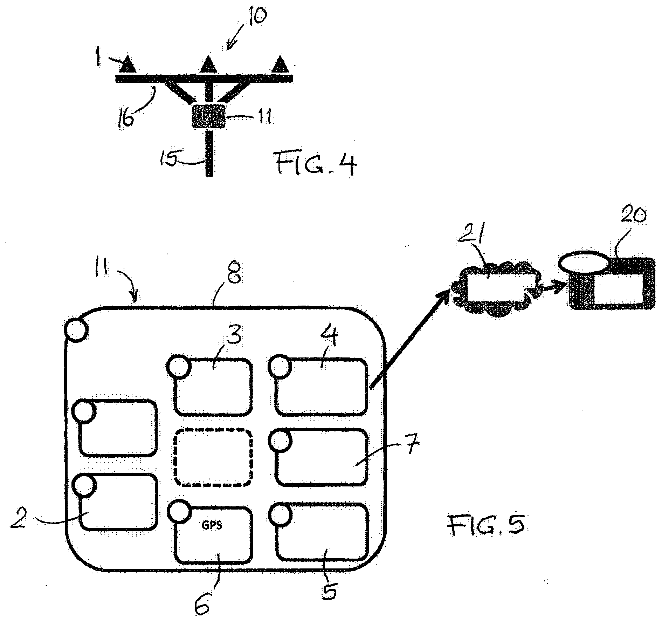

Figure 4 shows a measurement point 10 connected to the utility pole 15,comprising an on-site computer 11 on the utility pole 15 and measurement sensors 1 connected to the auxiliary cross-arm 16 of the utility pole 15. There is one measurement sensor 1 for each conductor and they are located at a distance of 1 m from the conductor.

Fig. 5 shows the structure of the on-site computer 11. It comprises voltage measurement 2, an apparatus 3 for measuring the voltage level and filtration of impulses, the impulse time stamping unit 3, telecommunications unit 4, power unit 5, GPS unit 6, CPU 7, weatherproof enclosure 8 and control centre 20. The telecommunications network is used in telecommunications as a normal client of the network.

Three sensors 1 are located on an auxiliary cross-arm 16 of the measurement point 10 and an on-site computer 11 on the utility pole, the main elements and functions of which are the following:
2) Voltage measurement data from sensors
3) Impulse filtration, counter and impulse time stamping
4) Telecommunications through the mobile telephone network from the measurement point to the control centre
5) Power supply and operating voltage
6) GPS receiver
7) CPU
8) Installation enclosure

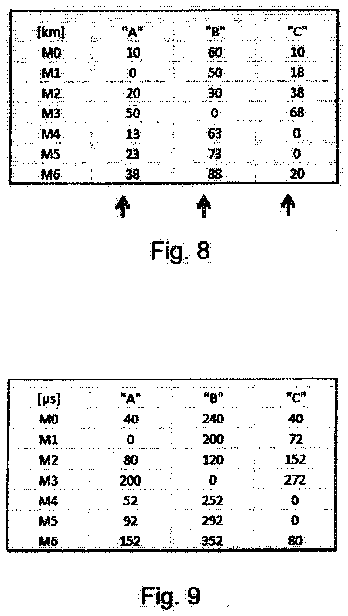

The table in Figure 6 shows the distances between the measurement points along a 20 kV conductor and the table in Figure 7 shows the travel delay time of the impulse between the measurement points.
The distances between the measurement points M1, M2, M3, M4, M5 and M6 are from the transformer substation M0. The speed of travel of the impulse in the medium-voltage grid is approximately 250 m/µs (metres per microsecond). When the installation locations of the measurement points and the speed of travel of the impulse are known, it is possible to calculate the travel delay time of the impulse between the measurement points in microseconds [µs], such as is presented in the table in Figure 7. The measurement points report the time-stamped measurement result in microseconds. The impact of the fault and the impulse it causes can hit any point of the medium-voltage grid. According to the method according to the invention, the measurement points measure the propagation of the impulse and time stamp the moment when the impulse passes the measurement point. In the tables shown in Figures 8 and 9 are presented three examples of fault locations "A", "B" and "C" in the electrical grid. The time-stamping values produced by the measurement points are shown in table 9 to the nearest microsecond. Based on them the distances shown in Figure 8 are calculated in kilometres at the control centre. The distances are specified as lengths of conductor by reporting the distance travelled by the impulse in the medium-voltage grid. The distance travelled by the impulse can be measured accurately, making it possible, according to the method, to receive precise data on the point of impact, i.e. the location of the fault. The values in the 0-km table indicate a point of impact that is in the immediate vicinity of the measurement point.

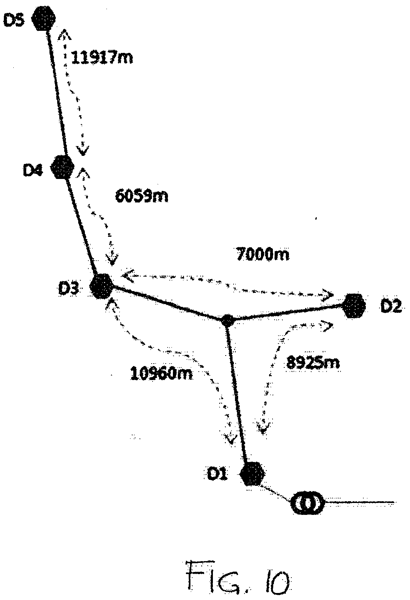

Figure 10 shows a diagram of a 20 kV electrical grid with the measurement points D1-D6. In this example, the total length of the electrical grid is 40 km and the distance between measurement points D3 and D4 along the conductor is 6,059 m.

Figures 11-13 show a "trend measurement", i.e. the graphical curve of the electric field E=V/m at the 20 kV electrical grid measurement points D2, D3 and D4 shown in Figure 10.

The graph in Figure 11 shows the values of the three-phase voltage fields measured at measurement point D2, similarly Figures 12 and 13 show the corresponding values of measurement points D3 and D4. The graphs in Figures 11-13 were measured in the same time period. The figures distinctly show that the measurement results at different measurement points are clearly different. In Figure 13 the changes in voltage are the strongest, so it predicts a disturbance situation near measurement point D4. At this stage, in the grid company's current grid monitoring devices according to prior art do not show anything exceptional. When the disturbance situation takes place it can be determined by comparing the curves in Figures 11-13 that the fault is near measurement points D3 and D4.

The on-site computer of measurement point D3 according to the invention reports the value of the time stamping counter as 590426 and similarly the on-site computer at measurement point D4 reports the value of the time stamping counter as 590434. The difference between these two is significant, i.e. 8 units. As the travel speed of the impulse is approximately 250 m/µs, the travel distance of the impulse is thus 8 x 250 m/µs, i.e. 2 km. This is shorter than the actual distance between measurement points D3 and D4, which is 6 km. Thus the impulse has started from between measurement points D3 and D4 at approximately 2 km from measurement point D3. If the impulse has started, for example, immediately next to measurement point D3 the time stamping counters' difference would have been 24 as 24 x 250 m/µs is 6 km. If we imagine a 6-km-long line between measurement points D3 and D4 and place the impulse's starting point 2 km from measurement point D3, an impulse leaves the starting point and travels in both directions. When the impulse has travelled for 8 microseconds it arrives at measurement point D3. At the same time the impulse has also travelled 8 x 250 m in the direction of measurement point D4. At the moment that measurement point D3 already detects the impulse, the impulse still has 2 km to travel to measurement point D4. It takes the impulse 8 microseconds to travel this final distance, which comes to a difference of 8 between the impulse counters of measurement points D3 and D4.

The following table shows a measurement result from an existing electrical grid, which corresponds to the example presented above.

**Outage at 12:33:**

| | | | | | | | | | |
|---|---|---|---|---|---|---|---|---|---|
| 36219064 | 2015-08-13 | 12:33:35.000 | D3 | 590426 | | L3 | | | |
| 36219028 | 2015-08-13 | 12:33:35.000 | D4 | 590434 | 8 | L4 | 24 | 2 | L3->L4 |

The table's calculation result shows that the location of the fault is 2 km from measurement point D3 in the direction of measurement point D4.

What is essential according to the invention is that the data from the conductor measurements is immediately available and that the prediction of a fault in the electrical grid or the isolation of the fault takes place immediately, i.e. in real time. There is no need for measures carried out after the fact, such as there is in many known methods.

### LIST OF REFERENCE NUMBERS

- 1: Measurement sensor
- 2: Apparatus for measuring the voltage level and detecting disturbance impulses
- 3: Impulse time stamping unit
- 4: Telecommunications unit
- 5: Power unit
- 6: GPS unit
- 7: CPU
- 8: Enclosure
- 10: Measurement point
- 11: On-site computer
- 15: Utility pole
- 16: Auxiliary cross-arm
- 17: Conductor
- 20: Control centre
- 21: Telecommunications network

## Claims

1. A method for locating a fault in a medium-voltage electrical grid, comprising the steps of
- several measurement points (10) are placed at some distance from one another along a three-phase power line, the measurement points including a measurement sensor (1) intended for each phase conductor (17) and placed at a distance from the phase conductor,
- using the measurement sensors (1), the strength of each phase conductor's voltage field is measured separately at the measurement point (10), and
- the location of the power line's disturbance and/or fault is predicted and/or isolated using a measurement of the change in the strength of the conductor's (17) voltage and/or voltage field, **characterized in that**
- a fault in the power line is located using remote detectors, which comprise said measurement sensors (1), the measurement sensors located in the vicinity of the conductors without touching the conductors, and
- fault in the power line is located using the voltage impulse occurring in the conductor's (17) voltage field, created by the fault, in such a way that the precise arrival time of the impulse is registered by the remote detectors at different measurement points (10) and the arrival times are compared with one another, whereby the distance of the fault from the different measurement points can be calculated and the location of the fault isolated in the electrical grid.

2. A method according to claim 1, wherein
- the several measurement points (10) are installed along a three-phase power line at a distance of 5-10 km from one another, each measurement point including a measurement sensor (1) for each phase conductor, and
- in the measurement point (10) a measurement sensors (1) are installed approximately 1 m from the phase conductors, whereby the voltage measurement takes place remotely and the measurement sensors are not galvanically coupled to the conductors.

3. A method according to claim 1 or 2, wherein the measurement sensors (1) are installed in 10 - 20 kV medium-voltage electrical grid about 1 m from the conductor (17) with the 10 - 20 kV line voltage turned on.

4. A method according to claim 1, 2 or 3 , wherein a fault occurring in the power line is predicted and located by means of the change in the strength of the conductor's voltage field in such a way that if, at the measurement point (10), the strength of the voltage field of a single phase conductor clearly changes compared to the strengths of the other phases' voltage fields, then the possible disturbance and/or fault emerging in the electrical grid is in the area in which the measurement point is located.

5. An apparatus for locating a fault in a medium-voltage electrical grid, which apparatus consists of several measurement points (10) located at a distance from one another along a power line in a three-phase electrical grid, each measurement point including a measurement sensor (1) intended for each phase conductor and placed at a distance from the phase conductor, and which measures the strength of the phase conductor's voltage field in order to anticipate and/or isolate the power line's disturbance and/or fault using the change in the strength of the conductor's voltage and/or voltage field, **characterized in that** the several measurement points (10) include
- remote detectors, which comprise the measurement sensors, the measurement sensors being located in the vicinity of the conductors without touching the conductors, and
- members measuring time, which maintain the electrical grid's measurement points at precisely synchronous time,
- members for detecting a voltage impulse in a conductor,
- members for registering the time that the voltage impulse arrives at the measurement point,
- members for reporting the arrival time of the impulse to the electrical grid's control centre, and
- at the control centre, members for isolating the location of the fault based on the arrival times of the impulses reported by the measurement points.

6. An apparatus according to claim 5, wherein
- several measurement points (10) are located along a three-phase 10 - 20 kV medium-voltage power line at a distance of 5-10 km from one another,
- each measurement point (10) includes a measurement sensor (1) for each phase conductor,
- each measurement sensor (1) is located approximately 1 m from the phase conductor,
- the measurement sensors are remote detectors, which are not galvanically coupled to the conductors, whereby the voltage measurement of the conductor takes place remotely.

7. An apparatus according to claim 5 or 6, wherein
- the measurement point (10) has a remote detector that measures the strength of the phase conductor's voltage field separately in the vicinity of each phase conductor, and
- the apparatus includes a voltage field strength comparison member for the phase conductors, the comparison member being arranged to anticipate immediately, i.e. in real time a fault in the electrical grid possibly occurring within the area of the measurement point (10) if the strength of the voltage field of one phase conductor at the measurement point deviates clearly from the strengths of the other phase conductors' voltage fields.

## Patentansprüche

1. Ein Verfahren zur Ortung eines Fehlers in einem Mittelspannungsstromnetz, das folgende Schritte umfasst:
- mehrere Messpunkte (10) werden in einiger Entfernung voneinander an einer dreiphasigen Stromleitung platziert, wobei die Messpunkte einen Messfühler (1) für jeden Phasenleiter (17) einschließen, der in einem Abstand vom Phasenleiter platziert ist,
- mithilfe der Messfühler (1) wird die Stärke des Spannungsfelds eines jeden Phasenleiters am Messpunkt (10) separat gemessen, und
- der Ort der Störung und/oder des Fehlers in der Stromleitung wird vorhergesagt und/oder isoliert, indem eine Messung der Veränderung in der Stärke der Spannung und/oder des Spannungsfelds des Phasenleiters (17) vorgenommen wird, **dadurch gekennzeichnet, dass**
- ein Fehler in der Stromleitung mithilfe entfernter Detektoren geortet wird, die die besagten Messfühler (1) umfassen, wobei die Messfühler in der Nähe der Leiter platziert sind, ohne die Leiter zu berühren, und
- ein Fehler in der Stromleitung geortet wird mithilfe des im Spannungsfeld des Leiters (17) auftretenden, durch den Fehler entstandenen Spannungsimpulses, derart, dass die genaue Ankunftszeit des Impulses von den entfernten Detektoren an unterschiedlichen Messpunkten (10) gemessen wird und die Ankunftszeiten miteinander verglichen werden. Dadurch kann der Abstand des Fehlers zu den unterschiedlichen Messpunkten berechnet werden und der Ort des Fehlers im Stromnetz isoliert werden.

2. Ein Verfahren nach Anspruch 1, bei dem
- die verschiedenen Messpunkte (10) entlang einer dreiphasigen Stromleitung in einem Abstand von 5-10 km voneinander platziert sind, wobei jeder Messpunkt einen Messfühler (1) für jeden Phasenleiter einschließt, und
- am Messpunkt (10) Messfühler (1) etwa 1 m von den Phasenleitern entfernt angebracht sind, sodass die Spannungsmessung aus der Entfernung erfolgt und die Messfühler mit den Leitern nicht galvanisch verbunden sind.

3. Ein Verfahren nach Anspruch 1 oder 2, bei dem die Messfühler (1) in einem Mittelspannungsstromnetz von 10-20 kV etwa 1 m vom Leiter (17) entfernt angebracht sind, wobei die Netzspannung von 10-20 kV eingeschaltet ist.

4. Ein Verfahren nach Anspruch 1, 2 oder 3, bei dem ein in der Stromleitung auftretender Fehler vorhergesagt und geortet wird mithilfe der Veränderung in der Stärke des Spannungsfelds des Leiters, derart, dass, wenn sich am Messpunkt (10) die Stärke des Spannungsfelds eines einzelnen Phasenleiters verglichen mit den Stärken der Spannungsfelder der anderen Phasen deutlich verändert, die mögliche Störung und/oder der mögliche Fehler im Stromnetz sich in dem Bereich befindet, in dem der Messpunkt platziert ist.

5. Eine Vorrichtung zur Ortung eines Fehlers in einem Mittelspannungsstromnetz, die aus mehreren Messpunkten (10) besteht, die entlang einer Stromleitung in einem dreiphasigen Stromnetz in einem Abstand voneinander platziert sind, wobei jeder Messpunkt für jeden Phasenleiter einen Messfühler (1) einschließt, der in einem Abstand zum Phasenleiter angebracht ist und der die Stärke des Spannungsfelds des Phasenleiters misst, um die Störung und/oder den Fehler in der Stromleitung vorherzusagen und/oder zu isolieren, wobei die Veränderung in der Stärke der Spannung und/oder des Spannungsfelds des Leiters genutzt wird,
**dadurch gekennzeichnet, dass** die verschiedenen Messpunkte (10) Folgendes einschließen:
- entfernte Detektoren, die mit Messfühlern (1) ausgestattet sind, wobei die Messfühler in der Nähe der Leiter platziert sind, ohne die Leiter zu berühren, und
- Bestandteile zur Zeitmessung, die die Messpunkte des Stromnetzes zeitlich genau synchron halten,
- Bestandteile zur Auffindung eines Spannungsimpulses in einem Leiter,
- Bestandteile zur Aufzeichnung des Zeitpunkts, an dem ein Spannungsimpuls am Messpunkt eintrifft,
- Bestandteile zur Meldung der Ankunftszeit des Impulses an das Kontrollzentrum des Stromnetzes sowie
- im Kontrollzentrum Bestandteile zur Ortung des Fehlers aufgrund der von den Messpunkten gemeldeten Ankunftszeiten der Impulse.

6. Eine Vorrichtung nach Anspruch 5, bei der
- die unterschiedlichen Messpunkte (10) entlang einer dreiphasigen Mittelspannungsstromleitung von 10-20 kV in einem Abstand von 5-10 km voneinander platziert sind,
- jeder Messpunkt (10) einen Messfühler (1) für jeden Phasenleiter einschließt,
- jeder Messfühler (1) etwa 1 m von dem Phasenleiter entfernt angebracht ist,
- die Messfühler entfernte Detektoren sind, die nicht galvanisch mit den Leitern verbunden sind, sodass die Spannungsmessung des Leiters aus der Entfernung erfolgt.

7. Eine Vorrichtung nach Anspruch 5 oder 6, bei der
- der Messpunkt (10) einen entfernten Detektor besitzt, der die Stärke des Spannungsfelds des Phasenleiters in der Nähe jedes Phasenleiters separat misst, und
- die Vorrichtung einen Bestandteil zum Vergleich der Spannungsfeldstärken für die Phasenleiter einschließt, wobei der Vergleichsbestandteil so angelegt ist, dass er unmittelbar, d. h. in Echtzeit, einen im Bereich des Messpunkts (10) möglicherweise auftretenden Fehler vorhersagen kann, wenn die Stärke des Spannungsfelds eines Phasenleiters deutlich von den Spannungsfeldstärken der anderen Phasenleiter abweicht.

## Revendications

1. Méthode pour localiser un défaut dans un réseau électrique de moyenne tension, comportant les étapes de
- plusieurs points de mesure (10) sont placés à une certaine distance les uns des autres sur une ligne électrique triphasée, les points de mesure incluant un capteur de mesure (1) prévu pour chaque conducteur de phase (17) et placé à distance du conducteur de phase,
- en utilisant les capteurs de mesure (1), la force du champ de tension de chaque conducteur de phase est mesurée séparément au point de mesure (10), et
- l'emplacement de la perturbation et/ou du défaut de la ligne électrique est prédit et/ou isolé en utilisant une mesure du changement de la force de la tension et/ou du champ de tension du conducteur (17), **caractérisée en ce que**
- un défaut dans la ligne électrique est localisé en utilisant des détecteurs à distance, qui comportent lesdits capteurs de mesure (1), les capteurs de mesure étant situés près des conducteurs, sans toucher les conducteurs, et
- défaut dans la ligne électrique est localisé en utilisant l'impulsion de tension générée dans le champ de tension du conducteur (17), créée par le défaut, de telle façon que le temps d'arrivée précis de l'impulsion est enregistré par les détecteurs à distance aux différents points de mesure (10) et que les temps d'arrivée sont comparés les uns aux autres, la distance du défaut par rapport aux différents points de mesure pouvant alors être calculée et l'emplacement du défaut dans le réseau électrique pouvant être isolé.

2. Méthode selon la revendication 1, dans laquelle
- les multiples points de mesure (10) sont installés, le long d'une ligne électrique triphasée, à une distance de 5 à 10 km les uns des autres, chaque point de mesure incluant un capteur de mesure (1) prévu pour chaque conducteur de phase (17), et
- au point de mesure (10), des capteurs de mesure (1) sont installés à environ 1 m des conducteurs de phase, la mesure de la tension ayant lieu à distance et les capteurs de mesure n'étant pas galvaniquement couplés aux conducteurs.

3. Méthode selon la revendication 1 ou 2, dans laquelle les capteurs de mesure (1) sont installés dans un réseau électrique de 10-20 kV de moyenne tension, à environ 1 m du conducteur (17), la tension de ligne de 10-20 kV étant connectée.

4. Méthode selon la revendication 1, 2 ou 3 , dans laquelle un défaut survenant dans la ligne électrique est prédit et localisé à l'aide du changement dans la force du champ de tension du conducteur de telle façon que si, au point de mesure (10), la force du champ de tension d'un conducteur monophasé change clairement par rapport aux forces des champs de tension des autres phases, la perturbation et/ou le défaut éventuel se produisant dans le réseau électrique se trouve dans la zone où le point de mesure est situé.

5. Un appareil pour localiser un défaut dans un réseau électrique de moyenne tension, l'appareil étant constitué de plusieurs points de mesure (10) situés à distance les uns des autres le long d'une ligne électrique triphasée, chaque point de mesure incluant un capteur de mesure (1) prévu pour chaque conducteur de phase et placé à distance du conducteur de phase, et qui mesure la force du champ de tension du conducteur de phase pour anticiper et/ou isoler la perturbation et/ou le défaut de la ligne électrique en utilisant le changement dans la force de la tension et/ou du champ de tension du conducteur,
**caractérisé en ce que** les multiples points de mesure (10) incluent
- des détecteurs à distance, qui comportent des capteurs de mesure, les capteurs de mesure étant situés près des conducteurs, sans toucher les conducteurs, et
- des membres mesurant le temps, qui maintiennent les points de mesure du réseau électrique exactement synchronisés en temps,
- des membres pour détecter une impulsion de tension dans un conducteur,
- des membres pour enregistrer le temps d'arrivée de l'impulsion de tension au point de mesure,
- des membres pour rapporter le temps d'arrivée de l'impulsion au centre de contrôle du réseau électrique, et
- au centre de contrôle, des membres pour isoler l'emplacement du défaut sur la base des temps d'arrivée des impulsions rapportés par les point de mesure.

6. Appareil selon la revendication 5, dans lequel
- plusieurs points de mesure (10) sont situés, le long d'une ligne électrique triphasée de moyenne tension de 10 de 20 kV, à une distance de 5 à 10 km les uns des autres,
- chaque point de mesure (10) inclut un capteur de mesure (1) pour chaque conducteur de phase,
- chaque capteur de mesure (1) est situé à environ 1 m du conducteur de phase,
- les capteurs de mesure sont des détecteurs à distance qui ne sont pas galvaniquement couplés aux conducteurs, la mesure de la tension du conducteur ayant lieu à distance.

7. Appareil selon la revendication 5 ou 6, dans lequel
- le point de mesure (10) a un détecteur à distance qui mesure la force du champ de tension du conducteur de phase séparément près de chaque conducteur de phase, et
- l'appareil inclut un membre de comparaison de force de champ de tension pour les conducteurs de phase, le membre de comparaison étant arrangé de façon à anticiper immédiatement, c.-à-d. en temps réel, un défaut dans le réseau électrique se produisant éventuellement dans la zone du point de mesure (10) si la force du champ de tension d'un conducteur de phase au point de mesure dévie clairement des forces des champs de tension des autres conducteurs de phase.
